Europäisches Patentamt

European Patent Office

Office européen des brevets

(19)

(11) Publication number: **0 153 889**
**A2**

(12) # EUROPEAN PATENT APPLICATION

(21) Application number: **85400247.4**

(22) Date of filing: **14.02.85**

(51) Int. Cl.⁴: **H 01 L 21/31**
**H 01 L 21/28, H 01 L 29/60**

(30) Priority: **29.02.84 US 584666**

(43) Date of publication of application:
**04.09.85 Bulletin 85/36**

(84) Designated Contracting States:
**DE FR GB IT NL**

(71) Applicant: **FAIRCHILD CAMERA & INSTRUMENT CORPORATION**
**464 Ellis Street**
**Mountain View California 94042(US)**

(72) Inventor: **Hsia, Yukun**
**12230 Saraglen Drive**
**Saratoga California 95070(US)**

(74) Representative: **Chareyron, Lucien et al,**
**Schlumberger Limited Service Brevets c/o Giers 12, place des Etats Unis B.P. 121**
**F-92124 Montrouge Cédex(FR)**

(54) **Deprogramming insensitive eprom process.**

(57) A process for improving the quality of an oxide thermally grown or doped polysilicon by doping the polysilicon so that the V I resistance of the polysilicon is less than approximately 3 ohms as measured by a companion single crystal test wafer The process applied to an EPROM device eliminates deprogramming defects in the device.

Fig. 1

EP 0 153 889 A2

DEPROGRAMMING INSENSITIVE EPROM PROCESS

Yukun Hsia

Field of the Invention

This invention relates to a process for improving the quality of an oxide thermally grown on doped polycrystalline silicon to produce an electrically programmable read only memory (EPROM) which is less sensitive to deprogramming, i.e., the loss of data on a previously programmed cell in the memory when another cell in the memory is programmed. In particular the invention relates to a process for inhibiting deprogramming in a memory whose memory cells contain a polycrystalline silicon (polysilicon) floating gate and to the improved memory resulting therefrom.

Background of the Invention

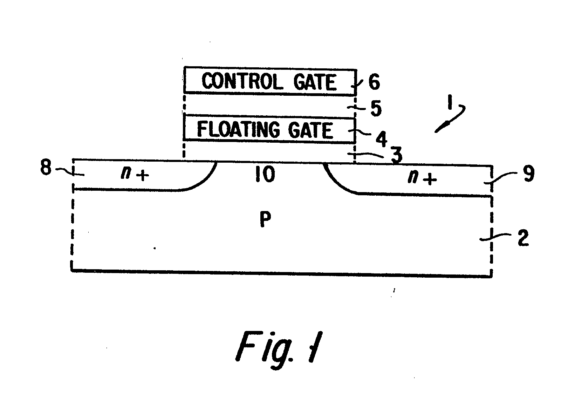

Figure 1 shows a schematic representation of a cross-section of a typical memory cell 1 in an EPROM which has a polysilicon floating gate. Memory cell 1 is part of an array of many such cells formed in a monolithic block of semiconductor material which is to become an integrated circuit. For simplicity only one such cell is shown in Figure 1. In the structure of Figure 1, a gate oxide layer 3 is formed on a silicon substrate 2 having a selected conductivity type. A first polysilicon floating gate layer 4 is formed over gate oxide layer 3. Polysilicon layer 4 is then doped, typically using phosphorous. In the prior art the dopant concentration in polysilicon gate 4 is light, the V/I resistance measurement in a companion single crystal test wafer being greater than 3 ohms. An oxide layer 5 is thermally grown on doped polysilicon gate layer 4, and a second polysilicon control gate layer 6 is formed over oxide layer 5.

EPROM cell 1 of Figure 1 is programmed by simultaneously applying a high voltage to its gate 6 and drain region 9. This causes electrons to be transported from channel region 10 to floating gate 4.

When another selected EPROM cell in the memory is being programmed, a high voltage, typically 12.5 to 25 volts is applied to either gate 6 or drain 9 of cell 1. Other voltages are also used, depending on the implementation of the circuit. Electrons "trapped" on floating gate 4 during the programming of cell 1 tend to "leak off", i.e., flow from the floating gate 4 through polysilicon oxide layer 5 to control gate 6 when a high voltage is applied to gate 6.

Most programmed memory cells sustain some leakage currents of electrons from their floating gate to their control gate through the polysilicon oxide layer 5 when adjacent memory cells are programmed. If the leakage current is excessive, the memory cell is deprogrammed.

The precise physical mechanism which causes deprogramming is not well understood.

An article by R. M. Anderson and D. R. Kerr, entitled "Evidence for Surface Asperity Mechanism of Conductivity in Oxide Grown on Polycrystalline Silicon", J. of Applied Physics, Vol. 48, No. 11, pp. 4834-36, November 1977, which is incorporated herein by reference, states that the presence of asperities on polycrystalline silicon (i.e., protrusions of polycrystalline silicon above the intended surface of the polycrystalline silicon) is strongly correlated with the conductivity observed in oxides grown on polycrystalline silicon. The role of asperities in causing enhanced conduction is attributed by Anderson and Kerr to tall, sharp asperities causing a local enhancement of the applied electric field which leads to Fowler-Nordheim electron emission from the asperities.

On the other hand, P. A. Hermann, et al., "Electrical Conduction Through Polysilicon Oxide: Interface Texture vs. Isolated Protuberances", J. Electrochem. Society, Vol. 130, No. 10, p. 2117-19, October 1983, which is incorporated herein by reference, observed that conduction through the polysilicon oxide arises from the enhanced electric fields at many small bumps and granular features found all over the polysilicon/polysilicon-oxide interface and not necessarily from a few relatively large asperities or protuberances as suggested by Anderson and Kerr.

In "Polysilicon/$SiO_2$ Interface Microtexture and Dielectric Breakdown, R. B. Marcus, et al., J. Electrochem, Soc., June 1982, Vol. 129, No. 6, p. 1282-89, which is incorporated herein by reference., four types of textural features are described at the polysilicon/polysilicon-oxide interface: interface roughness due to initial polysilicon surface texture, "bumps" caused by anomalous polysilicon nucleation at local sites of contamination, "protuberances" that occur during oxidation of the polysilicon, and inclusions of unoxidized silicon within the polysilicon oxide. The authors conclude that protuberances, bumps, and general interfacial roughness are all features which contribute to the lowering of dielectric breakdown of the polysilicon oxide through an increase in local electric fields at the tips of these features.

Still another hypothesis that may explain excessive electron flow from the floating gate to the control gate of an EPROM cell is that the edge of the polysilicon floating gate is too sharp, causing "horns" of silicon to form at the edge of the polysilicon gate during thermal oxidation of the polysilicon gate which causes stress hinderance of oxide growth at the corners of the polysilicon gate. See "Oxidation of Shaped Silicon Surfaces", R. B. Marcus, et al., J. Electrochem. Soc., June 1982, Vol. 129, No. 6, pgs. 1278-82.

A number of fabrication procedures have been suggested to avoid or reduce the deprogramming problem. RCA Laboratories has recently reported that deposition temperatures less than 580°C produce amorphous polysilicon, which has a considerably smoother surface than the polysilicon formed at standard temperatures (620°-640°C). The reduced roughness of the polysilicon gate layer should reduce asperity growth. See G. Horbeke, et al., "LPCVD Polycrystalline Silicon: Growth and Physical Properties of In-Site Phosphorous Doped and Undoped Films"; RCA Review, June 1983, Vol. 44, pp. 287-312; and M. T. Duffy, et al., "LPCVD Polycrystalline Silicon: Growth and Physical Properties of Diffusion - Doped, Ion Implanted, and Undoped Films"; RCA Review, June 1983, Vol. 44, pp. 313-329; which are incorporated herein by reference.

It has also been suggested that a high temperature anneal, at approximately 1000°C, be undertaken following the doping of the first polysilicon layer. See "LPCVD Polycrystalline Silicon: Growth and Physical Properties of In-Site Phosphorous Doped and Undoped Films" and "LPCVD Polycrystalline Silicon: Growth and Physical Properties of Diffusion - Doped, Ion Implanted, and Undoped Films", above.

An annealing step at approximately 1000°C after the formation of the control gate polysilicon layer is suggested by D. K. Brown, et al., "Ramp Breakdown Study of Double Polysilicon RAM's as a Function of Fabrication Parameters", J. Electrochem. Soc. July 1983, Vol. 130, No. 7, pp. 1597-1603, which is incorporated herein by reference.

C. C. Chang, et al., in "Phosphorous Depth Profiles in Thermally Oxidized P-Doped Polysilicon", J. Electrochem. Soc.; May 1983, Vol. 130, No. 5, pp. 1168-1171, which is incorporated herein by reference, propose a "sacrificial oxidation" of the polysilicon floating gate layer. In this process, a first dry oxide is grown on a first phosphorous doped polysilicon layer and then etched off and a second dry oxide layer is grown. This second dry oxide layer contains less phosphorous than the first sacrificial layer and is a better dielectric between the floating gate and the control gate, which thus tends to inhibit deprogramming.

It has also been found that increasing the temperature of the oxidation step following the deposition of the first polysilicon crystalline layer reduces the growth of asperities and produces a generally smoother polysilicon/ polysilicon-oxide interface. See Anderson, et al., above. For example, Anderson obtained substantially better results by increasing the oxidation temperature from 1000°C to 1150°C.

It has also been proposed to use HCL in the oxidation step. See D. K. Brown, et al., above.

Finally, D. K. Brown, et al., in "Ramp Breakdown Study of Double Polysilicon RAM's as a Function of Fabrication Parameters," supra, studied interelectrode ramp breakdown on double-polysilicon RAM's as a function of five fabrication parameters: (i) polysilicon thickness, (ii) polysilicon doping, (iii) removal of first-gate oxide (iv) oxidation of the second gate, and (v) post second gate thermal annealing. In particular it was found that the breakdown yield (i.e. the percentage of breakdown that occurred at a voltage of 30 or more volts) is extremely dependent on the phosphorous concentration in first polysilicon gate, with a lesser yield for the more heavily doped polysilicon gates. The concentrations studied ranged from 7.0 to $1.4 \times 10^{20}$ phosphorous atoms/cm$^3$ which corresponds to a sheet resistance of 11 ohms/sq to 18 ohms/sq. on a single crystal silicon test wafer.

In contrast to the results suggested by Brown, applicant has discovered that by even more heavily doping the first polysilicon gate, the quality of the oxide thermally grown on the first polysilicon gate is improved.

More specifically, heavily doping a polysilicon layer so that the sheet resistance in a single crystal test wafer is between approximately 4.5 ohms/sq. and 6.8 ohms/sq. improves the quality of the oxide thermally grown thereon.

## SUMMARY

A process is described for reducing leakage currents between a floating gate and a control gate by doping the floating gate to a selected resistance level. An oxide is thermally grown on the floating gate at a selected temperature.

The process is used to form an EPROM device which does not exhibit deprogramming defects.

## BRIEF DESCRIPTION OF THE DRAWING

Fig. 1 shows a cross section of a floating gate memory cell.

## DETAILED DESCRIPTION

Fig. 1 shows the cross-section of a stacked gate memory cell 10 of an EPROM formed in accordance with the teachings of applicant's invention. Fig. 1 is schematically the same as a prior art EPROM except for floating gate layer 4 and polysilicon oxide layer 5, as explained hereafter.

Substrate 2, typically formed of monocrystalline silicon of [100] orientation, is lightly doped with boron to achieve a resistivity in the range of 25 to 45 ohm-cm.

A gate oxide layer is formed on substrate 2 using $O_2$ and $H_2$ at a temperature of approximately 920°C for approximately 18 minutes to form gate oxide layer 12 approximately 800Å thick.

A first polysilicon layer is formed on the gate oxide layer using low pressure chemical vapor deposition.

The polysilicon deposition is followed by a $POCl_3$ doping process at 950°C to dope the polysilicon with phosphorous to a V/I resistance measurement of approximately 1.0 to 1.5 ohms on a companion single crystal test wafer. This corresponds to a sheet resistance of approximately 4.5 to 6.8 ohms/square. In accordance with our invention, we have discovered that contrary to expectation, this heavy doping serves to improve the quality of the oxide subsequently formed on the first polysilicon layer, which in turn inhibits deprogramming of the resultant EPROM device.

The resulting structure is then plasma etched to form a first polysilicon gate 4 and gate oxide 3 as shown in Fig. 1.

The resulting structure is then oxidized in an atmosphere of $O_2$ and approximately 3% HCL at a temperature of approximately 1050°C to grow an oxide layer approximately 850Å in thickness on doped polysilicon gate 4.

A second polysilicon layer is formed on the oxide layer grown on polysilicon gate 4 using a similar process as described for the first polysilicon layer and the resulting structure is etched using a standard etch process to form a second polysilicon gate 6 and the gate oxide 5 between first polysilicon gate 4 and second polysilicon gate 6 shown in Fig. 1.

The resulting structure, with its heavily doped first polysilicon gate 4, is then less sensitive to deprogramming. The heavy doping of the floating gate 4 to obtain a sheet resistivity of approximately 4.5 to 6.8 ohms/sq. improves the quality of the oxide layer 5 grown on the first doped polysilicon gate 4 in the sense that it reduces leakage currents between the floating gate 4 and the control gate 6 when a voltage is applied to control gate 6 during the programming of another selected cell in the memory.

While the above process has been explained in detail for the construction of a stacked polysilicon gate memory cell, it is obvious that the technique disclosed here of heavily doping a polysilicon layer with phosphorus can be used in any process where it is desired to improve the quality of a polysilicon oxide layer formed on the polysilicon layer.

Similarly, while the above process has been explained using phosphorus as a dopant, other N type dopants may also be used.

A specific optimal doping concentration range selected for the process illustrated above, namely doping the first polysilicon gate layer to achieve a preferred V/I resistance measurement of approximately 1 to 1.5 ohms on a companion single crystal test wafer. However, it has been established by experimentation that deprogramming is also inhibited with other heavily doped levels such that the first polysilicon gate layer is doped to obtain a V/I resistance measurement of less than approximately 3 ohms on a companion single crystal test wafer.

Similarly a doping temperature between approximately 900°C and 1100°C is used in this invention with 950°C being preferred.

The temperature used to grow the oxide layer 5 on the floating gate layer 4 in one embodiment of this invention is between 1000°C and 1150°C, with 1050° being preferred.

The table below summarizes a small representative sample of the results obtained for the specified processes studied, illustrating the excellent results obtained with the embodiments of this invention.

| Process Parameters | | bits sampled | bits deprogrammed | % deprogrammed |
|---|---|---|---|---|
| CONTROL PROCESS | | | | |
| V/I | = 3-4 ohms | 187,392 | 181 | .097 |
| IPOX temp. | = 1050°C | | | |
| doping temp. | = 900°C | | | |
| EXPERIMENTAL PROCESS | | | | |
| V/I | = 3-4 ohms | | | |
| IPOX temp. | = 1100°C | 254,464 | 7 | .003 |
| doping temp. | = 900°C | | | |
| EXPERIMENTAL PROCESS | | | | |
| V/I | = 1-1.5 ohms | | | |
| IPOX temp. | = 1050°C | 194,048 | 0 | 0 |
| doping temp. | = 1100°C | | | |
| PREFERRED PROCESS | | | | |
| V/I | = 1-1.5 ohms | | | |
| IPOX temp. | = 1050°C | 567,000 | 0 | 0 |
| doping temp. | = 950°C | | | |

In the above table the IPOX temperature is the temperature at which the oxide 5 is grown on the floating gate 4, the "interpoly oxide" temperature. The doping temperature refers to the temperature at which the floating gate is doped with phosphorus.

Of importance, when the V/I resistance was in the range of 1 to 1.5 ohms there were no deprogramming failures. The bits sampled were selected from resultant EPROM integrated circuits.

The specific embodiments presented in the specification are intended to serve by way of example only and are not to be construed as limitations on the scope of my invention. Many other embodiments of my invention will become apparent to those of ordinary skill in the art in light of the teachings of this specification.

CLAIMS

1.  A process for thermally growing an oxide layer on a doped polysilicon layer, characterized by doping the polysilicon layer with a selected dopant so that the resistance of the polysilicon layer is less than a value selected to improve the quality of said oxide layer so as to substantially eliminate charge leakage from said doped polysilicon layer through said oxide.

2.  The method of Claim 1 characterized in that said selected dopant is phosphorus.

3.  The method of Claim 1 or 2 characterized in that the resistance of said polysilicon layer is within a range of approximately 1 to 1.5 ohms.

4.  The method of Claim 1, 2 or 3, characterized by:
        forming a silicon oxide layer on a silicon substrate doped with a selected dopant;
        forming said polysilicon layer on said silicon oxide layer;
        practicing said doping step;
        forming a first polysilicon gate from said polysilicon layer;
        oxidizing said polysilicon gate in a selected ambient for a selected period of time at a selected temperature to form said oxide layer on said first polysilicon gate; and
        forming a second polysilicon layer on said polysilicon oxide layer to provide a stacked gate memory cell.

5.  The method of Claim 4 characterized in that said first polysilicon layer is doped with a selected dopant at a selected temperature so that the resistance of said first polysilicon layer as measured on a companion single crystal test wafer is within a range of approximately 1 to 1.5 ohms.

6.   The method of Claim 4 or 5 characterized in that said substrate is doped with boron.

7.   The method of any of Claims 4, 5 or 6 characterized in that said selected oxidation ambient is $O_2$ and approximately 3 percent HCl.

8.   The method of any of Claims 4, 5, 6 or 7 characterized in that said selected oxidation temperature is between approximately $1050^{\circ}C$ and $1150^{\circ}C$.

9.   The method of any of Claims 4, 5, 6 or 7 characterized in that said selected oxidation temperature is approximately $1050^{\circ}C$.

10.  The method of any of Claims 2 to 9 wherein said selected temperature for doping said first polysilicon layer with phosphorus is approximately $950^{\circ}C$.

11.  The products resulting from the process of Claims 1 through 10.

12.  A stacked memory cell comprising:
        a silicon substrate doped with a selected dopant;
        a first silicon oxide layer formed on said substrate;
        a first doped polysilicon layer formed on said first silicon oxide layer;
        a second silicon oxide layer grown on said first polysilicon oxide layer; and
        a second polysilicon layer formed on said second silicon oxide layer; characterized in that:
        said first doped polysilicon layer has a V/I resistance selected to substantially eliminate current leakage from said first doped polysilicon layer to said second polysilicon layer.

13. A stacked memory cell as in Claim 12 characterized in that said first doped polysilicon layer has a V/I resistance measured on a companion single crystal test wafer of approximately 1 to 1.5 ohms.

14. The stacked memory cell of Claim 12 or 13, characterized by:

a floating gate for storage of charge corresponding to said first doped polysilicon layer, said floating gate having a resistivity less than a selected value; and

a control gate corresponding to said second polysilicon layer overlying but insulated from said floating gate by said second oxide layer formed by thermally oxidizing said floating gate; and characterized in that:

the resistivity of said floating gate is controlled to be beneath a value selected to substantially eliminate current leakage from said floating gate to said control gate.

CONTROL GATE — 6
— 5
FLOATING GATE — 4
— 3
8 — $n+$    10    $n+$ — 9
P
— 2

*Fig. I*